# EUROPEAN PATENT SPECIFICATION

(11) **EP 4 601 010 B1**
(45) Date of publication and mention of the grant of the patent: **08.04.2026**
(21) Application number: 24157062.1
(22) Date of filing: 12.02.2024
(51) Int. Cl.: H10D 30/01, H10D 30/47, H10D 62/10, H10D 62/82, H10D 62/85, H10D 62/17, H10D 64/23

(54) **ELECTRIC FIELD MANAGEMENT IN A SEMICONDUCTOR-BASED TRANSISTOR DEVICE USING SEMICONDUCTOR OXIDE ISLANDS**
VERWALTUNG DES ELEKTRISCHEN FELDES IN EINER HALBLEITERBASIERTEN TRANSISTORVORRICHTUNG MIT HALBLEITEROXIDINSELN
GESTION DE CHAMP ÉLECTRIQUE DANS UN DISPOSITIF DE TRANSISTOR À BASE DE SEMI-CONDUCTEUR UTILISANT DES ÎLOTS D'OXYDE SEMI-CONDUCTEUR

(43) Date of publication of application: 13.08.2025
(73) Proprietor: Huawei Technologies Co., Ltd., Shenzhen, Guangdong 518129 (CN)
(72) Inventor: Curatola, Gilberto, Munich (DE); Mouhoubi, Samir, Munich (DE)
(74) Representative: Körber, Martin Hans

(56) References cited:
- CN-A- 113 066 864
- JP-A- 2008 034 438
- US-A1- 2013 140 578

## Description

### TECHNICAL FIELD

The present disclosure relates to a semiconductor-based transistor device, for instance, to a high-electron-mobility transistor (HEMT), which may be based on gallium nitride (GaN). The disclosure provides such a transistor device, and a method for fabricating the transistor device. The disclosure is especially concerned with electric field management in the transistor device.

### BACKGROUND

GaN technology for power applications is being developed by most established semiconductor power manufactures, and holds the great promise to replace conventional silicon technology. The main advantages of wide bandgap materials, like GaN or silicon carbide (SiC), include the capability of withstanding higher electric fields for the same design of a drift region, for example. This translates into the possibility of having smaller power devices compared to conventional silicon counterparts. Moreover, wide bandgap materials offer a smaller device capacitance, and the possibility to reach a higher switching frequency. These benefits at system level are easily translated into better performance, higher power density, and smaller weight and volume of the system.

One key difference of, for example, the GaN technology compared to the conventional silicon technology for power transistor devices is that GaN is a lateral technology. This means that the gate, the source and the drain contacts of a transistor device are arranged on the same surface, and the current flows in a lateral direction rather than in a vertical direction like in conventional silicon power MOSFETs. This has the big advantage that the device performance can be adjusted by simply changing the lateral layout.

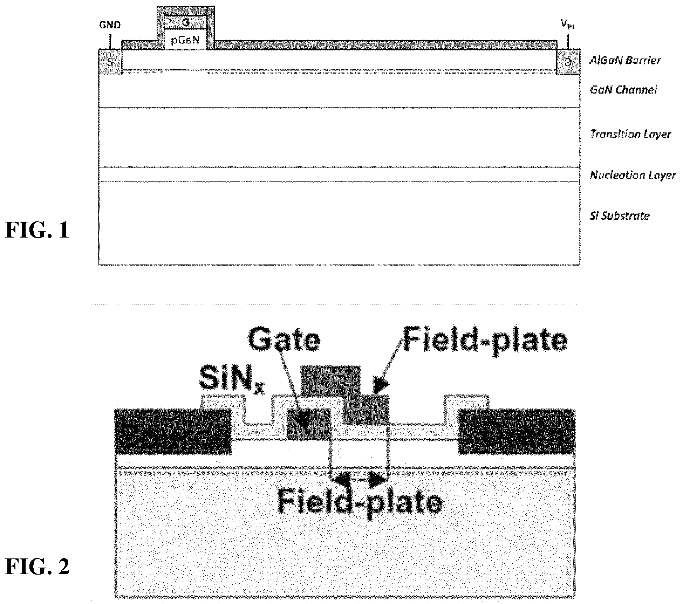

A common approach that is followed by most GaN manufacturers is the so-called p-GaN approach. In this approach an aluminum gallium nitride (AlGaN) barrier is grown on top of a GaN channel layer. Due to the presence of spontaneous and piezoelectric polarization charge, a high density electron inversion layer is formed at the interface between the AlGaN barrier layer and the GaN channel layer. In order to deplete this two-dimensional electron gas (2DEG) - also referred to as channel in this disclosure - below a gate region, a p-type doped GaN layer is inserted between a metal gate layer and the AlGaN barrier, only in the gate region. This allows achieving a normally-off operation, i.e., a positive threshold voltage. A schematic representation of an exemplary p-GaN transistor device is depicted in FIG. 1.

One of the key issues of any power MOSFET is the trade-off between the device performance and its reliability. In particular, to improve the device reliability and its robustness, it is very important to perform an accurate electric field management. A common approach in this respect is to employ so-called field plates, which are effectively metal plates (or polysilicon plates) with the main role of lowering the maximum electric field peaks during device operation. This helps to improve the overall device lifetime. Generally, those metal field plates are connected to a fixed potential, like the source potential. A penalty that is generally encountered when using such field plates is the loss of performance, due to the added capacitance. A schematic representation of a power transistor that employs such field plates is shown in FIG. 2.

US 2013/140578 A1 discloses discloses a HEMT comprising p-doped nickel oxide or zinc oxide islands located directly on a barrier as well as said islands being positioned in a discontinuous pattern in a direction perpendicular to the current flow. D1 does not disclose the presence of a passivation layer as well as the plurality of islands arranged partly on the barrier layer and partly on the passivation layer.

JP 2008 034438 A discloses a HEMT with a p-type metal oxide semiconductor layer for surface stabilization.

### SUMMARY

The present disclosure and its solutions are further based on the following considerations. As previously discussed, electric field management in power transistor devices, for instance in GaN based HEMTs, can be of vital importance. Conventionally, metal field plates are employed to reduce the maximum electric field in the transistor device, and hence improve the overall reliability. However, this comes at the expense of some performance loss, because of the extra capacitance introduced by the added metal field plates.

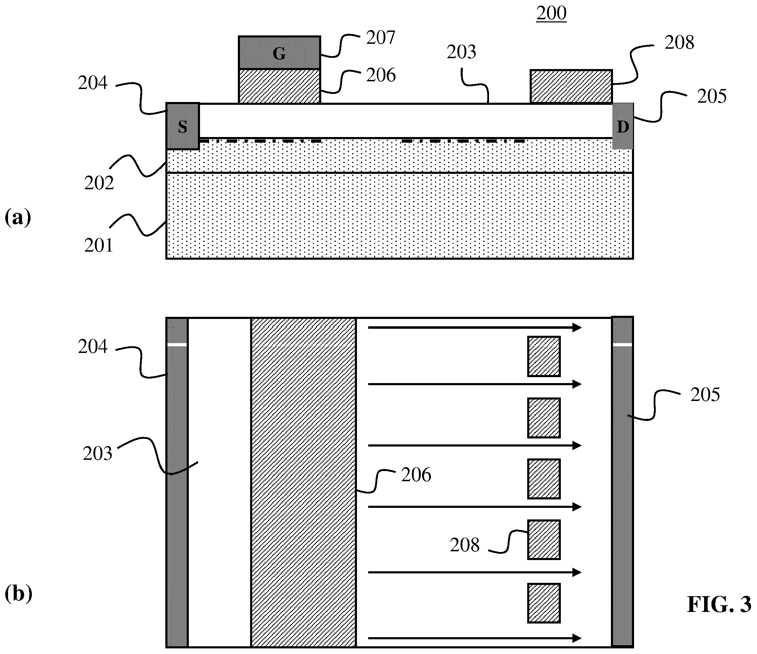

FIG. 3(a) and 3(b) show an exemplary alternative solution not falling under the scope of the present invention, which may be used in the GaN technology FIG. 3(a) shows a cross-sectional view of an exemplary transistor device 200, while FIG. 3(b) shows the top view. The solution employs additional p-GaN regions 208 on the barrier layer 203. In particular, the same p-GaN layer that is used for the gate regions (see the p-GaN gate layer 206 beneath the metal gate 207) is used in proximity of the drain contact 205 to form the p-GaN regions 208 with a two-fold objective. Firstly, to reduce the maximum electric field at the side of the drain contact 205. Secondly, to allow the injection of holes into the channel layer 202 and buffer layer 201, and help reducing possible dynamic effects during device operation.

The p-GaN layer may be first grown, for instance, in a metal organic chemical vapor deposition (MOCVD) tool. Then, during lithography steps that are employed to define the gate regions, where the p-GaN gate layer 206 will be used to deplete the channel (i.e., the 2DEG) and allow a normally-off operation, some portions of the p-GaN layer are intentionally kept (and not removed during following etching steps) as the regions 208 in the proximity of the drain contact 205. The main goal is to reduce the maximum electric field at the side of the drain contact 204, and also to allow, during high drain-to-source voltage operation, the injection of holes into the GaN channel layer 202. The injection of these positive charges into the GaN channel 202 layer helps to reduce possible trapping effects, and a consequent current collapse and dynamic drain-source on-resistance (RDSon) phenomena.

The main disadvantage of this solution not falling under the scope of the present invention and shown in FIG. 3 is that, the regions 208 of the p-GaN layer at the side of the drain contact 205 depletes the channel (i.e., the 2DEG) underneath in exactly the same way as it happens in the gate region(s). As a consequence, even with a positive voltage applied to the gate electrode 207, there could be no lateral current conduction from source contact 204 to drain contact 205, since the channel is interrupted under the p-GaN layer regions 208 at the drain contact side. For this reason, as shown in FIG. 3(b) in the top view of the device 200, the p-GaN regions 208 are defined in a discontinuous pattern (as discrete regions or islands), which allows to still have lateral current conductions in the areas where the p-GaN is not present. As evident, this solution induces a reduction of the maximum electric field at the drain contact side, but at the expense of a significant current reduction.

In view of the above, an objective of this disclosure is to provide a transistor device that allows overcoming the issues that affect the conventional approaches. An objective is to achieve a reduction in the maximum electric field, but without the compromise in performance loss. A particular objective is to reduce the maximum electric field in specifically the regions where it is used and, hence, to strongly improve the overall device reliability. Another objective is a reduction of the impact of the dynamic RDSon and current collapse on the overall device performance. A further objective is a boost in current drive capability to improve the device performance.

These and other objectives are achieved by the solutions of this disclosure as described in the appended claims.

A first aspect of this disclosure provides a semiconductor-based transistor device according to claim 1.

The transistor device of the first aspect overcomes most issues that affect the conventional approaches. With the discrete regions, a reduction in the maximum electric field is achieved, but without the compromise in performance loss. This is due to the fact that the discrete regions are provided on the passivation layer, which is not possible in conventional approaches. The discrete regions cause the reduction in the maximum electric field without fully depleting the channel below. The channel is provided by a high density electron inversion layer in the form of a 2DEG, which is formed at the interface of channel layer and the barrier layer in the channel layer, due to the presence of spontaneous and piezoelectric polarization charge. The discrete regions can be arranged to reduce the maximum electric field in specifically the regions where needed. The dynamic RDSon and current collapse on the overall device performance may be avoided.

In an implementation form of the first aspect, the first semiconductor material is GaN, and the second semiconductor material is AlGaN.

In an implementation form of the first aspect, the semiconductor oxide material is nickel oxide (NiO) or is lithium nickel oxide (LiNiO), or is diamond.

According to the invention the discrete regions are p-doped.

According to the invention, the semiconductor oxide layer comprise discrete regions that are arranged partly on the passivation layer and partly in direct contact with the barrier layer.

This can be used to promote the injection of holes into the channel layer. Moreover, the lateral current conduction from source to drain contact can be tailored.

In an implementation form not falling under the scope of the claims, the semiconductor oxide layer comprises at least one discrete region that is arranged in the proximity of or in contact with the drain contact.

In an implementation form not falling under the scope of the claims, a part of the drain contact is arranged on the at least one discrete region that is arranged in the proximity of or in contact with the drain contact.

In an implementation form of the first aspect, the semiconductor oxide layer comprises a plurality of discrete regions arranged in a discontinuous pattern, wherein each discrete region is arranged at least partly on the passivation layer.

In an implementation form of the first aspect, the semiconductor oxide layer comprises a plurality of discrete regions arranged one after the other along an axis, wherein the axis is perpendicular to a channel formed between the source contact and the drain contact in the channel layer, and wherein each discrete region is arranged at least partly on the passivation layer.

In an implementation form of the first aspect, the plurality of discrete regions are arranged at regular intervals along the axis.

In an implementation form not falling under the scope of the claims, the semiconductor oxide layer comprises one discrete region that extends along an axis perpendicular to a channel formed between the source contact and the drain contact in the channel layer, wherein the discrete region extends over most or all of a width of the channel along the axis.

For instance, at least one discrete region may be a large continuous portion of semiconductor oxide material, for instance, crossing the entirety of the channel layer.

In an implementation form not falling under the scope of the claims, the semiconductor oxide layer comprises at least one discrete region that is arranged in the proximity of or adjacent to the gate stack.

In an implementation form not falling under the scope of the claims, the semiconductor oxide layer comprises at least one discrete region that is embedded in the passivation layer.

In an implementation form not falling under the scope of the claims, the passivation layer is arranged on and around the gate stack, and the at least one discrete region is embedded in the part of the passivation layer that is arranged on and around the gate stack.

These discrete regions may function like conventional field plates.

In an implementation form of the first aspect, each discrete region is an island of semiconductor oxide material and/or configured as a plate.

In an implementation form of the first aspect, the gate stack includes any one of: a p-doped GaN gate layer arranged on the barrier layer, and a metal gate layer arranged on the p-doped GaN gate layer; or a metal gate layer arranged on the barrier layer; or an insulator layer arranged on the barrier layer, and a metal gate layer arranged on the insulator layer.

Thus, different gate structures can be used with the transistor device of the first aspect. The insulator layer may be a dielectric layer, like a silicon nitride layer, or an oxide layer, like a silicon oxide, aluminum oxide, or hafnium oxide layer. The metal gate layer may be any suitable metal, for instance, gold, titanium, platinum, aluminum, or palladium, or the like. Notably, the solutions of this disclosure do not depend on the particular gate stack considered, but is independent therefrom. A different gate stack than exemplified above could be chose, and the solutions will still apply. As example, instead of a p-GaN approach, a metal-oxide approach, a recess-approach, or any other gate stack approach that has been proposed in the field in the past years could be applied.

In an implementation form of the first aspect, the transistor device is a HEMT.

A second aspect of this disclosure provides a method of fabricating a semiconductor-based transistor device according to claim 9.

In an implementation form of the first aspect, the semiconductor oxide layer is formed by sputtering NiO or LiNiO at least partly directly onto the passivation layer and/or at least partly onto the barrier layer.

Sputtering is not possible in the exemplary approach, in which p-GaN regions are formed by growth on the barrier layer.

The present disclosure accordingly proposes the use a different material than p-GaN for the formation of discrete regions, also referred to as islands. For example, the material used for forming the discrete regions may be NiO or LiNiO or diamond. Notably, NiO or LiNiO or diamond are natural p-type oxide semiconductors, and a high doping concentration can be easily achieved due to spontaneously formed Ni vacancies or O interstitials. As an advantage NiO or LiNiO films can be prepared by many methods including e-beam evaporation, magnetron sputtering, atomic layer deposition, pulsed plasma deposition, thermal oxidation, spin coating, metal-organic chemical vapor deposition, etc. Among these methods, magnetron sputtering has been extensively used because of high film quality, selective area deposition, low cost, and large thickness. An advantage of the solution is thus that the discrete regions can thus be sputtered on the pre-existing passivation layer, which cannot be done for p-GaN material that is grown in a MOCVD tool. With the proposed solution, the full 2DEG depletion in the region below the discrete regions can be avoided. The semiconductor oxide layer comprising the discrete regions will, however, still cause a reduction in the maximum electric field, due to a depletion region caused by the semiconductor oxide / passivation layer / 2DEG junction.

### BRIEF DESCRIPTION OF DRAWINGS

The above described aspects and implementation forms are explained in the following description in relation to the enclosed drawings, in which:
- FIG. 1: shows a schematic representation not falling under the scope of the invention of a conventional normally-off p-GaN HEMT.
- FIG. 2: shows a schematic representation not falling under the scope of the invention of a transistor device that employs a field plate.
- FIG. 3: shows a schematic representation not falling under the scope of the invention of an exemplary normally-off p-GaN HEMT with p-GaN islands used for electric field management (cross-sectional view and top view).
- FIG. 4: shows a transistor device not falling under the scope of the invention with discrete semiconductor oxide material regions arranged on a passivation layer.
- FIG. 5: shows a current flow in a transistor device not falling under the scope of the invention, which has the discrete semiconductor oxide material regions arranged on the passivation layer.
- FIG. 6: shows a transistor device not falling under the scope of the invention with discrete semiconductor oxide material regions arranged on the passivation layer and covered by the drain contact.
- FIG. 7: shows a transistor device according to the present invention with discrete semiconductor oxide material regions arranged partly on the passivation layer and partly on the barrier layer.
- FIG. 8: shows a current flow in a transistor device according to the present invention, which has the discrete semiconductor oxide material regions arranged partly on the passivation layer and partly on the barrier layer.
- FIG. 9: shows a transistor device not falling under the scope of the invention with discrete semiconductor oxide material regions acting as field plates and embedded in the passivation layer.
- FIG. 10: shows a method of fabricating a semiconductor-based transistor device according to this disclosure.

### DETAILED DESCRIPTION OF EMBODIMENTS

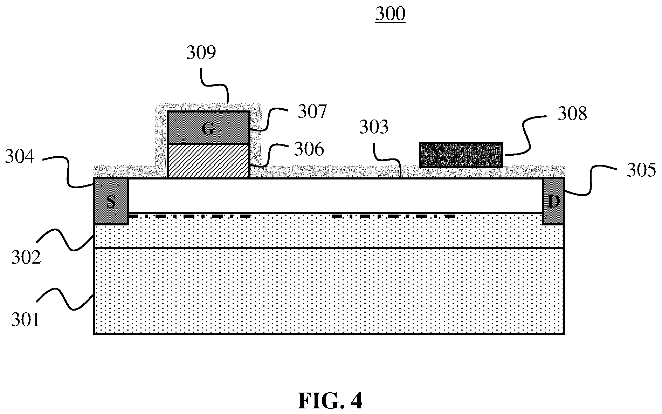

FIG. 4 shows a semiconductor-based transistor device 300 not falling under the scope of the invention. The transistor device 300 may be based on GaN and/or SiC and/or on another wide bandgap semiconductor material. The transistor device 300 may be a HEMT. The transistor device 300 may be suitable for power applications. In the following, particularly a GaN based transistor device 300 is described, but just as an example.

The transistor device 300 comprises a buffer layer 301, which is made of a first semiconductor material, in the described example the first semiconductor material is GaN. Further, the transistor device 300 comprises a channel layer 302, which is made of the first semiconductor material, and is arranged on the buffer layer 301. Further, a barrier layer 303 made of a second semiconductor material is arranged on the channel layer 302, wherein in the described example the second semiconductor material is AlGaN.

The transistor device 300 further comprises a gate stack, which is arranged on the barrier layer 303. The gate stack comprises at least one gate layer. As an example, the gate stack in FIG. 4 comprises a p-doped GaN gate layer 306, which is arranged on the barrier layer 303, and a metal gate layer 307 that is arranged on the p-doped GaN gate layer 306. Alternatively, the gate stack could include a different structure. For instance, the gate stack may include a metal gate layer arranged at least partially on the barrier layer 303, so as to form a Schottky gate. Alternatively, the gate stack could include an insulator layer arranged at least partially on the barrier layer 303, and a metal gate layer arranged on the insulator layer, so as to form a metal-insulator-semiconductor (MIS) gate. The gate stack may be formed according to any one of these alternatives likewise in any transistor device 300 described in this disclosure.

The transistor device 300 further comprises a source contact 304 and a drain contact 305, which are respectively connected to the channel layer 302 (at opposite device ends, for instance). Moreover, a passivation layer 309 covers at least the part of the barrier layer 303 that is not covered by the gate stack. The passivation layer 309 may further cover the gate stack and may also surround the gate stack.

The transistor device 300 further comprises a semiconductor oxide layer made of a semiconductor oxide material. The semiconductor oxide layer comprises at least one discrete region 308 that is arranged at least partly on the passivation layer 309. In FIG. 4 the at least one discrete region 308 of the semiconductor oxide material is arranged completely on the passivation layer 309, as an example.

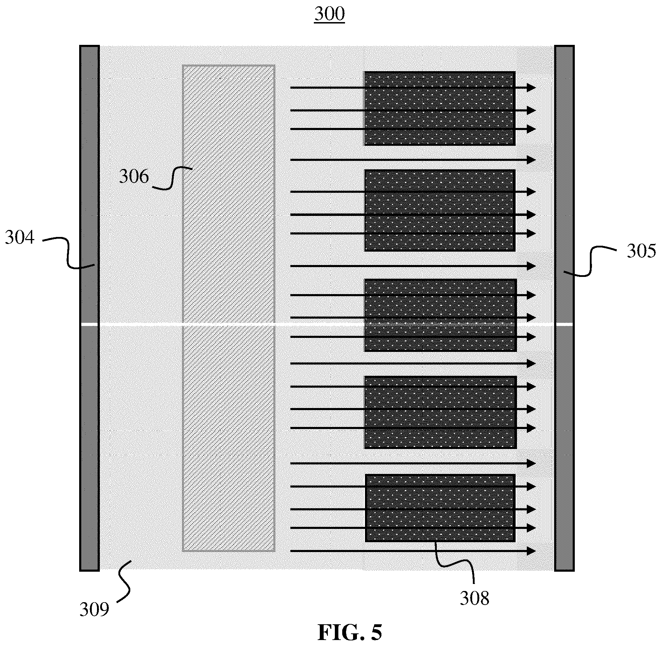

FIG. 5 shows a current flow in a transistor device 300 not falling under the scope of the invention, which has the previously described discrete semiconductor oxide material regions 308, which are completely arranged on the passivation layer 309. The transistor device 300 of FIG. 5 may be the transistor device 300 of FIG. 4. Same elements in FIG. 4 and FIG. 5 are labelled with the same reference signs, and may be implemented likewise.

FIG. 5 illustrates that current can flow from the source contact 304 to the drain contact 305 in the channel, which is formed at the interface of channel layer 302 and barrier layer 303, even beneath the discrete regions 308. In particular, an advantage of the proposed solution not falling under the scope of the invention shown on FIG. 4 or 5 is that the discrete regions 308 on the passivation layer 309 allow to avoid the full 2DEG depletion in the areas below the discrete regions 308. This could not be done for p-GaN material grown in a MOCVD tool (onto the barrier layer 303). The discrete semiconductor oxide material regions 308 will still achieve a reduction in the maximum electric field thanks to a depletion region they cause. Another advantage of the solution with the discrete regions 309 is that the semiconductor oxide material can be sputtered on the pre-existing passivation layer 309. The semiconductor oxide material may be p-type NiO or LiNiO.

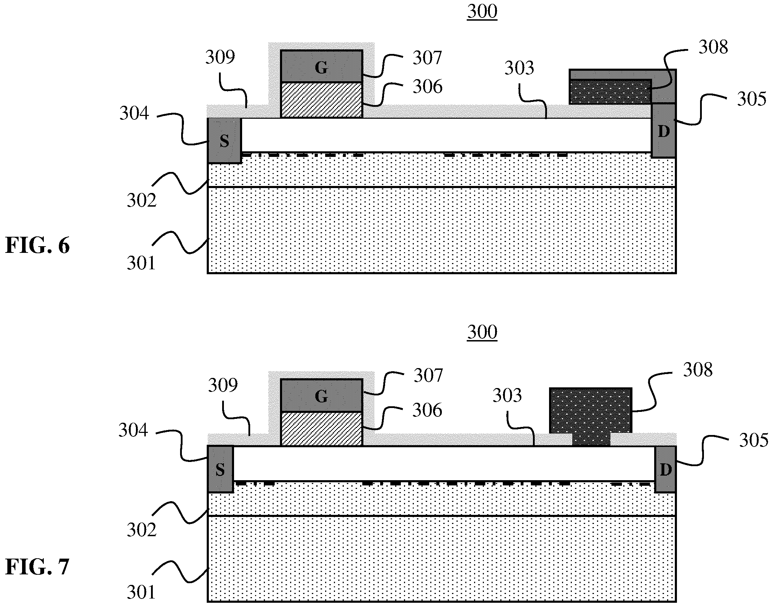

FIG. 6 shows another transistor device 300 not falling under the scope of the invention. Same elements in FIG. 6 and FIG. 4 are labelled with the same reference signs, and may be implemented likewise. In the transistor device 300 of FIG. 6, a part of the drain contact 305 is arranged on at least one discrete region 308. The at least one discrete region 308 is arranged in the proximity of, or in contact with, the drain contact 305.

FIG. 7 shows another transistor device 300 according to the invention. Same elements in FIG. 7 and FIG. 4 are labelled with the same reference signs, and may be implemented likewise. In the transistor device 300 of FIG. 7, at least one discrete region 308 is arranged partly on the passivation layer 309 and partly in direct contact with the barrier layer 303.

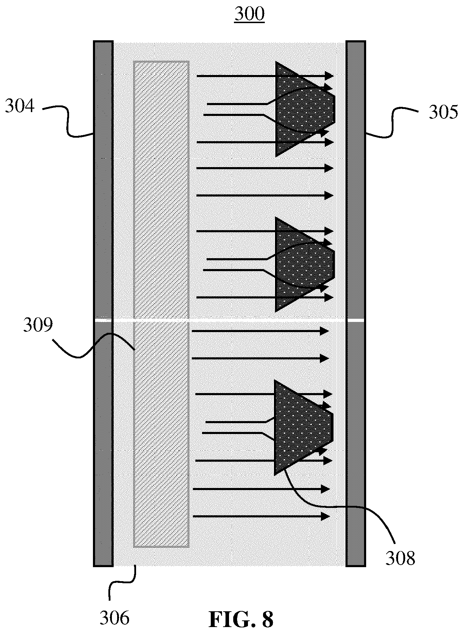

FIG. 8 shows a current flow in a transistor device 300 according to the invention, which has the discrete semiconductor oxide material regions 308 arranged partly on the passivation layer 309 and partly on the barrier layer 303. The transistor device 300 of FIG. 8 may be the transistor device 300 of FIG. 7. Same elements in FIG. 7 and FIG. 8 are labelled with the same reference signs, and may be implemented likewise.

FIG. 8 illustrates that current can flow from the source contact 304 to the drain contact 305 in the channel, but not beneath the discrete regions 308 in this example (at least where the discrete regions 308 are arranged directly on the barrier layer 303). The advantages of this approach can be summarized as follows. Firstly, in the areas where the semiconductor oxide material is deposited on top of the passivation layer 309, a reduction in the maximum electric field will be induced without impacting significantly the lateral current conduction. Secondly, in the areas where the semiconductor oxide material is in direct contact with the barrier layer 303, this will deplete the 2DEG underneath and induce a reduction in the overall lateral current conductions. However, this will also promote the injection of holes into the channel layer 302, and hence can improve the dynamic effect management in the transistor device 300. Thirdly, the two-dimensional layout and the ration between the areas where the semiconductor oxide material is deposited on top of the passivation layer 309, and the areas where it is in direct contact with the barrier layer 303, can be easily tuned by modifying the layout.

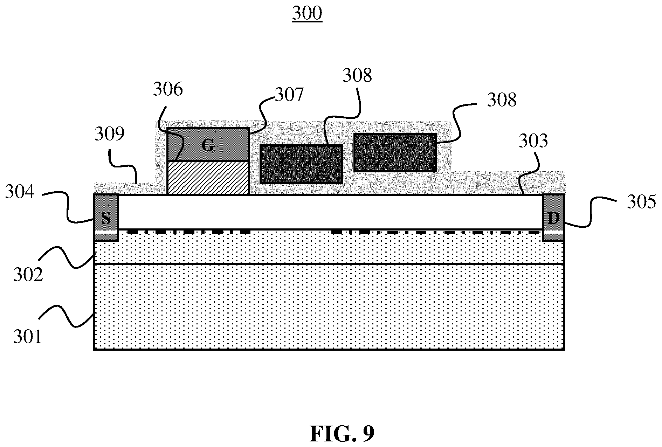

FIG. 9 shows a transistor device 300 not falling under the scope of the invention. Same elements in FIG. 9 and FIG. 4 are labelled with the same reference signs, and may be implemented likewise. In the transistor device 300 of FIG. 9, at least one discrete region 308 is arranged as a field plate in the passivation layer 309. One or more used field plates may lower the maximum electric field peaks during the operation of the transistor device 300, and may thus help improving the overall lifetime of the transistor device 300.

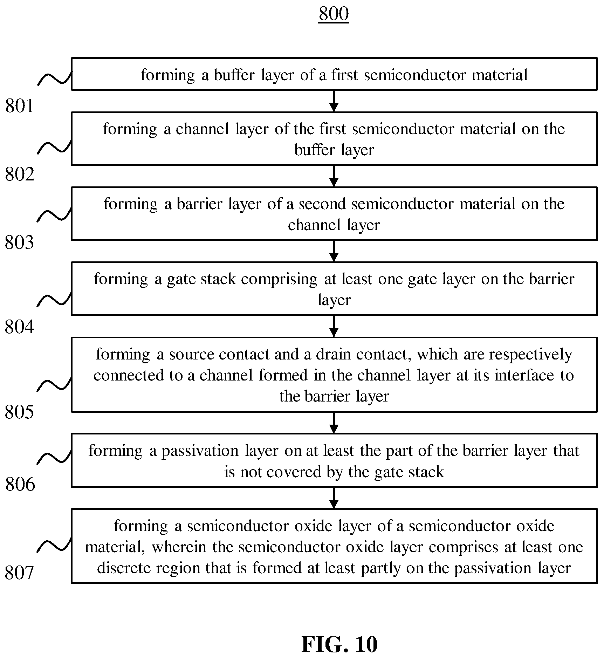

FIG. 10 shows a method 800 of fabricating a semiconductor-based transistor device 300 according to this disclosure. For example, the method 800 may yield any one of the before-described transistor devices 300.

The method 800 comprises a step 801 of forming a buffer layer 301 of a first semiconductor material, for instance, GaN.

Further, the method 800 comprises a step 802 of forming a channel layer 302 of the first semiconductor material on the buffer layer 301, and a step 803 of forming a barrier layer 303 of a second semiconductor material, for instance AlGaN, on the channel layer 302. The method 800 also comprises a step 804 of forming a gate stack comprising at least one gate layer 306, 307 on the barrier layer 303, and a step 805 of forming a source contact 304 and a drain contact 305 respectively connected to the channel layer 302. In a step 806, a passivation layer 309 is formed on at least the part of the barrier layer 303 that is not covered by the gate stack. The method 800 further comprises a step 807 of forming a semiconductor oxide layer of a semiconductor oxide material, wherein the semiconductor oxide layer comprises at least one discrete region 308 that is formed at least partly on the passivation layer 309. It is noted however that the method of fig. 10 falls within the scope of the present invention only when a plurality of discrete regions 308 are formed, each being arranged partly on the passivation layer and partly in direct contact with the barrier layer.

In particular, the discrete regions 308 of the semiconductor oxide layer may be formed by sputtering the semiconductor oxide material - e.g. NiO or LiNiO - at least partly directly onto the passivation layer 309. For instance, the semiconductor oxide material may be sputtered completely on the passivation layer 309, or may be sputtered partly onto the passivation layer 309 and partly onto the barrier layer 303.

The present disclosure has been described in conjunction with various embodiments as examples as well as implementations.

However, other variations can be understood and effected by those persons skilled in the art and practicing the claimed matter, from the studies of the drawings, this disclosure and the independent claims. In the claims as well as in the description the word "comprising" does not exclude other elements or steps and the indefinite article "a" or "an" does not exclude a plurality. A single element or other unit may fulfill the functions of several entities or items recited in the claims. The mere fact that certain measures are recited in the mutual different dependent claims does not indicate that a combination of these measures cannot be used in an advantageous implementation.

The scope of the present invention is defined solely by the appended claims.

## Claims

1. A semiconductor-based transistor device (300) comprising:
a buffer layer (301) made of a first semiconductor material;
a channel layer (302) made of the first semiconductor material and arranged on the buffer layer (301);
a barrier layer (303) made of a second semiconductor material and arranged on the channel layer (302);
a gate structure comprising at least one gate layer (306, 307), the gate structure being arranged on the barrier layer (303);
a source contact (304) and a drain contact (305), which are respectively connected to a channel formed in the channel layer (302) at its interface to the barrier layer;
a passivation layer (309) covering the part of the barrier layer (303) that is not covered by the gate structure; and
a semiconductor oxide layer made of a semiconductor oxide material, wherein the semiconductor oxide layer comprises a plurality of p-doped discrete regions (308);
wherein each discrete region (308) of the plurality of discrete regions (308) is arranged partly on the passivation layer (309) and partly in direct contact with the barrier layer (303); and
wherein the plurality of discrete regions (308) is arranged in a discontinuous pattern; or wherein the plurality of discrete regions (308) is arranged one after the other along an axis, wherein the axis is perpendicular to a channel formed between the source contact (304) and the drain contact (305) in the channel layer (302).

2. The transistor device (300) of claim 1, wherein the first semiconductor material is GaN, and the second semiconductor material is AlGaN.

3. The transistor device (300) of claim 1 or 2, wherein the semiconductor oxide material is nickel oxide, NiO, or is lithium nickel oxide, LiNiO, or is diamond.

4. The transistor device (300) of one of the claims 1 to 3, wherein the plurality of discrete regions (308) is arranged at regular intervals along the axis.

5. The transistor device (300) of one of the claims 1 to 4, wherein the gate structure includes any one of:
a p-doped GaN gate layer (306) arranged on the barrier layer (303), and a metal gate layer (307) arranged on the p-doped GaN gate layer (306); or
a metal gate layer arranged on the barrier layer (303): or
an insulator layer arranged on the barrier layer (303), and a metal gate layer arranged on the insulator layer.

6. The transistor device (300) of one of the claims 1 to 5, wherein the transistor device (300) is a high-electron-mobility transistor, HEMT.

7. A method (800) of fabricating a semiconductor-based transistor device (300), the method (800) comprising:
forming (801) a buffer layer (301) of a first semiconductor material;
forming (802) a channel layer (302) of the first semiconductor material on the buffer layer (301);
forming (803) a barrier layer (303) of a second semiconductor material on the channel layer (302);
forming (804) a gate structure comprising at least one gate layer (306, 307) on the barrier layer (303);
forming (805) a source contact (304) and a drain contact (305), which are respectively connected to a channel formed in the channel layer (302) at its interface to the barrier layer;
forming (806) a passivation layer (309) on at least the part of the barrier layer (303) that is not covered by the gate structure; and
forming (807) a semiconductor oxide layer of a semiconductor oxide material, wherein the semiconductor oxide layer comprises a plurality of p-doped discrete regions (308),
wherein each discrete region (308) of the plurality of discrete regions (308) is arranged partly on the passivation layer (309) and partly in direct contact with the barrier layer (303); and
wherein the plurality of discrete regions (308) is arranged in a discontinuous pattern; or wherein the plurality of discrete regions (308) is arranged one after the other along an axis, wherein the axis is perpendicular to a channel formed between the source contact (304) and the drain contact (305) in the channel layer (302).

8. The method (800) of claim 7, wherein the semiconductor oxide layer is formed by sputtering NiO or LiNiO at least partly directly onto the passivation layer (309) and/or at least partly onto the barrier layer (303).

## Patentansprüche

1. Transistorvorrichtung auf Halbleiterbasis (300), umfassend:
eine Pufferschicht (301), die aus einem ersten Halbleitermaterial gefertigt ist;
eine Kanalschicht (302), die aus dem ersten Halbleitermaterial gefertigt ist und auf der Pufferschicht (301) angeordnet ist;
eine Barriereschicht (303), die aus einem zweiten Halbleitermaterial gefertigt ist und auf der Kanalschicht (302) angeordnet ist;
eine Gate-Struktur, die mindestens eine Gate-Schicht (306, 307) umfasst, wobei die Gate-Struktur auf der Barriereschicht (303) angeordnet ist;
einen Source-Kontakt (304) und einen Drain-Kontakt (305), die jeweils mit einem Kanal verbunden sind, der in der Kanalschicht (302) an deren Grenzfläche zu der Barriereschicht gebildet ist;
eine Passivierungsschicht (309), welche den Teil der Barriereschicht (303) bedeckt, der nicht von der Gate-Struktur bedeckt ist; und
eine Halbleiteroxidschicht, die aus einem Halbleiteroxidmaterial gefertigt ist, wobei die Halbleiteroxidschicht eine Vielzahl von p-dotierten diskreten Regionen (308) umfasst;
wobei jede diskrete Region (308) der Vielzahl von diskreten Regionen (308) teilweise auf der Passivierungsschicht (309) und teilweise in direktem Kontakt mit der Barriereschicht (303) angeordnet ist; und
wobei die Vielzahl von diskreten Regionen (308) in einem diskontinuierlichen Muster angeordnet ist; oder wobei die Vielzahl von diskreten Regionen (308) eine nach der anderen entlang einer Achse angeordnet ist, wobei die Achse rechtwinklig zu einem Kanal ist, der zwischen dem Source-Kontakt (304) und dem Drain-Kontakt (305) in der Kanalschicht (302) gebildet ist.

2. Transistorvorrichtung (300) gemäß Anspruch 1, wobei das erste Halbleitermaterial GaN ist, und das zweite Halbleitermaterial AlGaN ist.

3. Transistorvorrichtung (300) gemäß Anspruch 1 oder 2, wobei das Halbleiteroxidmaterial Nickeloxid, NiO, ist, oder Lithiumnickeloxid, LiNiO, ist, oder Diamant ist.

4. Transistorvorrichtung (300) gemäß einem der Ansprüche 1 bis 3, wobei die Vielzahl von diskreten Regionen (308) in regelmäßigen Intervallen entlang der Achse angeordnet ist.

5. Transistorvorrichtung (300) gemäß einem der Ansprüche 1 bis 4, wobei die Gate-Struktur eines der folgenden einschließt:
eine p-dotierte GaN-Gate-Schicht (306), die auf der Barriereschicht (303) angeordnet ist, und eine Metall-Gate-Schicht (307), die auf der p-dotierten GaN-Gate-Schicht (306) angeordnet ist; oder
eine Metall-Gate-Schicht, die auf der Barriereschicht (303) angeordnet ist; oder
eine Isolatorschicht, die auf der Barriereschicht (303) angeordnet ist, und eine Metall-Gate-Schicht, die auf der Isolatorschicht angeordnet ist.

6. Transistorvorrichtung (300) nach einem der Ansprüche 1 bis 5, wobei die Transistorvorrichtung (300) ein Transistor mit hoher Elektronenbeweglichkeit, HEMT, ist.

7. Verfahren (800) zum Fertigen einer Transistorvorrichtung auf Halbleiterbasis (300), wobei das Verfahren (800) Folgendes umfasst:
Bilden (801) einer Pufferschicht (301) aus einem ersten Halbleitermaterial;
Bilden (802) einer Kanalschicht (302) aus dem ersten Halbleitermaterial auf der Pufferschicht (301);
Bilden (803) einer Barriereschicht (303) aus einem zweiten Halbleitermaterial auf der Kanalschicht (302);
Bilden (804) einer Gate-Struktur, die mindestens eine Gate-Schicht (306, 307) umfasst, auf der Barriereschicht (303);
Bilden (805) eines Source-Kontakts (304) und eines Drain-Kontakts (305), die jeweils mit einem Kanal verbunden sind, der in der Kanalschicht (302) an deren Grenzfläche zu der Barriereschicht gebildet ist;
Bilden (806) einer Passivierungsschicht (309) auf mindestens dem Teil der Barriereschicht (303), der nicht durch die Gate-Struktur bedeckt ist; und
Bilden (807) einer Halbleiteroxidschicht eines Halbleiteroxidmaterials, wobei die Halbleiteroxidschicht eine Vielzahl von p-dotierten diskreten Regionen (308) umfasst;
wobei jede diskrete Region (308) der Vielzahl von diskreten Regionen (308) teilweise auf der Passivierungsschicht (309) und teilweise in direktem Kontakt mit der Barriereschicht (303) angeordnet ist; und
wobei die Vielzahl von diskreten Regionen (308) in einem diskontinuierlichen Muster angeordnet ist; oder wobei die Vielzahl von diskreten Regionen (308) eine nach der anderen entlang einer Achse angeordnet ist, wobei die Achse rechtwinklig zu einem Kanal ist, der zwischen dem Source-Kontakt (304) und dem Drain-Kontakt (305) in der Kanalschicht (302) gebildet ist.

8. Verfahren (800) gemäß Anspruch 7, wobei die Halbleiteroxidschicht durch Sputtern von NiO oder LiNiO mindestens teilweise direkt auf die Passivierungsschicht (309) und/oder mindestens teilweise auf die Barriereschicht (303) gebildet wird.

## Revendications

1. Dispositif transistor à base de semi-conducteur (300) comprenant :
une couche tampon (301) constituée d'un premier matériau semi-conducteur ;
une couche de canal (302) constituée du premier matériau semi-conducteur et agencée sur la couche tampon (301) ;
une couche de barrière (303) constituée d'un second matériau semi-conducteur et agencée sur la couche de canal (302) ;
une structure de grille comprenant au moins une couche de grille (306, 307), la structure de grille étant agencée sur la couche de barrière (303) ;
un contact de source (304) et un contact de drain (305), qui sont respectivement connectés à un canal formé dans la couche de canal (302) à son interface avec la couche de barrière ;
une couche de passivation (309) recouvrant la partie de la couche de barrière (303) qui n'est pas recouverte par la structure de grille ; et
une couche d'oxyde de semi-conducteur constituée d'un matériau d'oxyde de semi-conducteur, la couche d'oxyde de semi-conducteur comprenant une pluralité de régions discrètes dopées p (308) ;
chaque région discrète (308) de la pluralité de régions discrètes (308) étant agencée en partie sur la couche de passivation (309) et en partie en contact direct avec la couche de barrière (303) ; et
la pluralité de régions discrètes (308) étant agencée selon un motif discontinu ; ou la pluralité de régions discrètes (308) étant agencée l'une après l'autre le long d'un axe, l'axe étant perpendiculaire à un canal formé entre le contact de source (304) et le contact de drain (305) dans la couche de canal (302).

2. Dispositif transistor (300) selon la revendication 1, le premier matériau semi-conducteur étant du GaN, et le second matériau semi-conducteur étant de l'AlGaN.

3. Dispositif transistor (300) selon la revendication 1 ou 2, le matériau d'oxyde de semi-conducteur étant de l'oxyde de nickel, NiO, ou de l'oxyde de lithium-nickel, LiNiO, ou du diamant.

4. Dispositif transistor (300) selon l'une des revendications 1 à 3, la pluralité de régions discrètes (308) étant agencée à intervalles réguliers le long de l'axe.

5. Dispositif transistor (300) selon l'une des revendications 1 à 4, la structure de grille comprenant l'un quelconque parmi :
une couche de grille en GaN dopée p (306) agencée sur la couche de barrière (303), et une couche de grille métallique (307) agencée sur la couche de grille en GaN dopée p (306) ; ou
une couche de grille métallique agencée sur la couche de barrière (303) ; ou
une couche isolante agencée sur la couche de barrière (303), et une couche de grille métallique agencée sur la couche isolante.

6. Dispositif transistor (300) selon l'une des revendications 1 à 5, le dispositif transistor (300) étant un transistor à haute mobilité d'électrons, HEMT.

7. Procédé (800) de fabrication d'un dispositif transistor à base de semi-conducteur (300), le procédé (800) comprenant :
la formation (801) d'une couche tampon (301) d'un premier matériau semi-conducteur ;
la formation (802) d'une couche de canal (302) du premier matériau semi-conducteur sur la couche tampon (301) ;
la formation (803) d'une couche de barrière (303) d'un second matériau semi-conducteur sur la couche de canal (302) ;
la formation (804) d'une structure de grille comprenant au moins une couche de grille (306, 307) sur la couche de barrière (303) ;
la formation (805) d'un contact de source (304) et d'un contact de drain (305), qui sont respectivement connectés à un canal formé dans la couche de canal (302) à son interface avec la couche de barrière ;
la formation (806) d'une couche de passivation (309) sur au moins la partie de la couche de barrière (303) qui n'est pas recouverte par la structure de grille ; et
la formation (807) d'une couche d'oxyde de semi-conducteur d'un matériau d'oxyde de semi-conducteur, la couche d'oxyde de semi-conducteur comprenant une pluralité de régions discrètes dopées p (308) ;
chaque région discrète (308) de la pluralité de régions discrètes (308) étant agencée en partie sur la couche de passivation (309) et en partie en contact direct avec la couche de barrière (303) ; et
la pluralité de régions discrètes (308) étant agencée selon un motif discontinu ; ou la pluralité de régions discrètes (308) étant agencée l'une après l'autre le long d'un axe, l'axe étant perpendiculaire à un canal formé entre le contact de source (304) et le contact de drain (305) dans la couche de canal (302).

8. Procédé (800) selon la revendication 7, la couche d'oxyde de semi-conducteur étant formée par pulvérisation de NiO ou de LiNiO au moins en partie directement sur la couche de passivation (309) et/ou au moins en partie sur la couche de barrière (303).
